# EUROPEAN PATENT APPLICATION

(11) **EP 1 253 817 A2**
(43) Date of publication of application: **30.10.2002**
(21) Application number: 02008778.9
(22) Date of filing: 19.04.2002
(51) Int. Cl.: H05K 13/04

(54) **Apparatus for picking and placing small objects**

(30) Priority: 23.04.2001 CH 7322001
(71) Applicant: LICONIC AG, 9485 Nendeln (LI)
(72) Inventor: The designation of the inventor has not yet been filed
(74) Representative: Blum, Rudolf Emil Ernst

(57) **Abstract**

The invention relates to an apparatus for picking and placing small objects. It is equipped with a tool holder (222) that can be positioned in an X-, Y- and Z-direction. A pickup tool (401) is mounted to the tool holder and can be rotated about a vertical axis. A microscopic and a macroscopic camera (301, 303) with non-parallel axes are arranged on the tool holder for viewing the objects from above, and a lookup camera (506) is provided to view the objects from below. The housing (1) of the apparatus as well as a first movable frame (20) are formed by perpendicular walls (101, 102, 103, 201a - 201e), which are light but provide stability for placing the tools accurately. An object dispenser (601) is located below a transfer opening (505) of a working platform (501) of the apparatus for quick access to new objects. A control unit (7) provides a graphical user interface for controlling the operation of the apparatus.

## Description

The invention relates to an apparatus for picking and placing small objects, in particular an apparatus for picking and placing microelectronic components. The invention also relates to a displacement device for displacing a first member in respect to a second member.

In modern production technology, the handling of microscopically small objects is of increasing importance. The objects have to be picked up from a dispenser and must be placed in a precise orientation and position at a desired target located on a working platform. Typical applications are e.g. the placing of dies (chips) into a housing or of optical components onto a substrate. A further example is the placing of electronic components in flip chip technology.

Conventionally, manual or automated apparatus is used. Automated apparatus is usually equipped with powerful cameras and image processing software for autonomously locating and placing the objects. Manual systems are equipped with a microscope-type viewer and are controlled by a user. While the manual systems are much less expensive than automated ones, they are slow and their operation requires considerable skill.

The problem to be solved by the present invention is to provide an apparatus of the type mentioned above that allows an accurate and quick positioning of the objects on the working platform. This problem is solved by the apparatus and method of the independent claims.

Preferably and in order to allow to place the objects quickly, the object dispenser is arranged below the working platform and can be reached through a transfer opening arranged therein. This makes the distance between dispenser and target location shorter.

In another preferred embodiment, two horizontal guide rails are mounted to a back wall of the housing with slides running along them. The slides are carrying a movable frame having two vertical side walls with the tool holder mounted between them. The two vertical side walls stiffen the frame and make the apparatus therefore more accurate.

In a further preferred embodiment at least two cameras are mounted to the tool holder for imaging the objects with different resolution. The camera with higher resolution can be used as a microscope for viewing a close-up view of the object, while the camera with lower resolution can be used as a macroscope to gain an overview of the area surrounding the object. Using two cameras permits to display microscopic and macroscopic views simultaneously or to quickly switch between them.

In yet another preferred embodiment, a camera is mounted to the tool holder and directed along a camera axis. The control unit of the apparatus stores a distance from the camera axis to the pickup point for calculating the offset between a pixel in an image of the camera from the pickup point.

In a further aspect, the invention also relates to displacement device for displacing a first member in respect to a second member or an apparatus as mentioned above with such a displacement device. The displacement device has first and second rollers arranged at the first member and third and fourth rollers arranged at the second member. The third and fourth roller have different diameters and are connected to rotate about a common axis. A single loop belt is guided around the first and second roller. The belt contacts the third and fourth rollers from opposite sides such that when the belt is moving, the third and fourth rollers are displaced in respect to the first member with a velocity proportional to the difference of the two roller diameters.

Such a device allows to move the two members with high resolution if the difference of the diameters of the third and fourth rollers is sufficiently small.

Finally, the invention relates to a method for operating the apparatus described above. In this method, an object is displayed before it is picked up. At least two predefined points in the display are identified manually for measuring the position and rotation of the object in respect to the camera. Then, a target (such as a chip housing) is displayed. Again, two points are manually identified for measuring its position and rotation. Using the positions and rotations defined in this way, the object can be positioned accurately at a predefined position of the target.

Further preferred embodiments of the invention are listed in the dependent claims as well as in the following description and the figures, which show
Fig. 1 a view of a preferred embodiment of the apparatus of the present invention with some parts thereof removed,
Fig. 2 a front view of the embodiment of Fig. 1,
Fig. 3 a view of an object dispenser,
Fig. 4 a side view of a first embodiment of a displacement device with part of the belt shown transparent in dashed lines,
Fig. 5 a top view of the device of Fig. 4,
Fig. 6 a view of a second embodiment of the displacement device,
Fig. 7 a first part of a user interface for operating the apparatus,
Fig. 8 a second part of the user interface for operating the apparatus,
Fig. 9 a third part of the user interface for operating the apparatus, and
Fig. 10 steps of a typical procedure for picking up and placing an object.

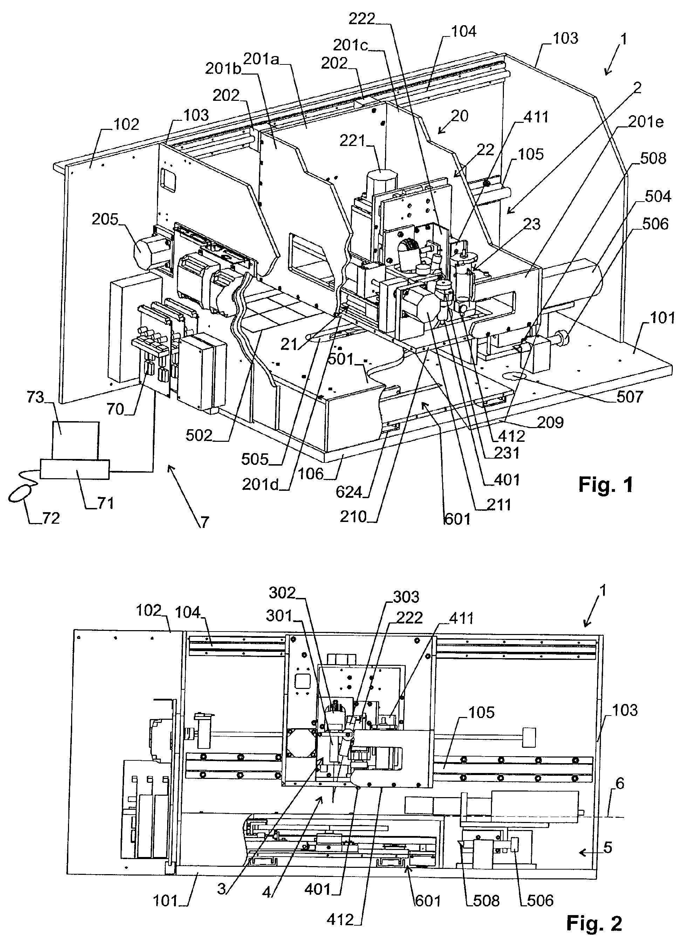

A preferred embodiment of an apparatus according to the present invention is shown in Figs. 1 and 2. The apparatus comprises a stationary housing 1 having a horizontal bottom wall 101, a vertical back wall 102 and vertical side walls 103.

A positioning table 2 for positioning alignment optics 3 and a set of tools 4 is mounted to housing 1. It comprises three movable frames 20, 21, 22. A first movable frame 20 is mounted in housing 1 and is displaceable thereto along a horizontal X-direction. A second movable frame 21 mounted to first movable frame 20 and is displaceable thereto along a horizontal Y-direction. A third movable frame 22 is mounted to second frame 21 and is displaceable thereto along a vertical Z-direction.

A working level 6 defined by a plate shaped horizontal working platform 501 extends parallel to bottom wall 101 with room for a utility space 5 located between working level 6 and bottom wall 101. A control unit 7 comprising control circuitry 70 and a computer 71 controls the operation of the apparatus. Computer 71 comprises an input device, such as a mouse 72, and a display 73 and provides a user interface as described below.

The walls 101, 102 and 103 of housing 1 are perpendicular to each other and provide a stiff but light stationary frame for the apparatus.

A smaller upper horizontal guide rail 104 and a stronger lower horizontal guide rail 105 are mounted to back wall 102 and extend into the horizontal X-direction parallel to front edge 106 of bottom wall 101.

First movable frame 20 of positioning table 2 is slideably mounted to back wall 102. It rides with upper slides 202 on upper guide rail 104 and with lower slides (not shown) on lower guide rail 105. First movable frame 20 comprises a first movable vertical back wall 201a, first movable vertical side walls 201b, 201c, a first movable bottom wall 201d and a first movable front wall 201e. The walls of first movable frame 20 are perpendicular to and connected with each other to form a mechanically stiff but light unit. An X-motor 205 is provided for moving first frame 20 long the X-direction.

Second movable frame 21 of positioning table 2 is slideably mounted on first movable frame 20 and can be displaced along a horizontal Y-direction perpendicular to the Y-direction by a Y-motor 211.

Third movable frame 22 of positioning table 2 is slideably mounted on second movable frame 21 and can be displaced along a vertical Z-direction perpendicular to the X- and Y-directions by a Z-motor 221.

Third movable frame 22 carries a tool holder 222 located between the first movable side walls 201b, 201c. Mounted to tool holder 222 are the alignment optics 3 and a rotatable frame 23. Rotatable frame 23 can be rotated about a vertical rotation axis by means of a rotation motor 231. Rotatable frame 23 serves to pick up the objects during transport.

For increasing the stiffness of the apparatus, first movable frame 20 comprises a support 209 (shown transparent in Fig. 1 and not shown in Fig. 2) mounted to a forward end 210 of the frame remote from the upper and lower slides 202. Support 209 is connected to bottom wall 101 of housing 1 for sliding along the x-direction and transferring lifting forces from forward end 210 to housing 1. Support 209 reduces an undesired movement of first movable frame 20 when applying pressure on an object to be positioned.

The set of tools 4 comprises non-rotatable tools directly mounted to third movable frame 22 and rotatable tools mounted to rotatable frame 23. The rotatable tools comprise a pickup tool 401 designed as a vacuum chuck, which is aligned concentrically to the rotation axis of rotation motor 231. Pickup tool 401 is designed for taking up an object from a pickup point below tool holder 222 and transferring it over working platform 501.

Pickup tool 401 can apply defined amount of pressure on an object during placement on target, such as a chip housings indicated schematically by reference numeral 502. Pickup tool 401 can further be equipped with a heat source, e.g. for soldering.

The non-rotatable tools may e.g. comprise an adhesive dispenser 412 arranged on a vertical lift 411. It is used to apply adhesive to a location where an object is to be placed. Lift 411 has a bottom and a top position. In the bottom position, the outlet of adhesive dispenser 412 is at the same height as the vacuum sucker of the pickup tool.

Working platform 501 located at working level 6 can be used for holding the targets (such as chip housings or printed circuit boards) where the objects are to be placed. It can also be used for holding any type of devices of limited height.

Alignment optics 3 comprises a first, microscope camera 301 and a light source 302 mounted to tool holder 222. Microscope camera 301 is aligned along a first, vertical camera axis and records a microscopic image with high resolution (i.e. with a large number of dots per given length). Alignment optics 3 also comprises a second, macroscopic camera 303, which is also mounted to tool holder 22 and aligned along a second camera axis. Macroscopic camera 303 depicts a macroscopic image with a larger size but a lower resolution (i.e. with a smaller number of dots per given length) than microscopic camera 302. The axes of the cameras 301 and 303 intersect in an acute angle at the height of working level 6, and the cameras are focused on this intersection point, which is at the same height as the periferical surface of tool set 4.

The distance ("camera offset") between the camera axis of microscopic camera 301 and the pickup point of pickup tool 401 (i.e. distance between the camera axis of microscopic camera 301 and the rotation axis of the rotatable frame) is known from calibration measurements and stored in control unit 7.

Working platform 501 can e.g. be used for storing chip housings. An adjustment camera 504 is arranged horizontally beside working platform 501 such that its camera axis lies in working level 6. Working platform 501 and working level 6 are located at a distance above bottom wall 101 to generate room for utilities called utility space 5.

An object dispenser 601 (best seen in Fig. 2) is arranged in utility space 5 below working platform 501. Utility space 5 also provides room for a lookup camera 506, a light source 507 and a folding mirror - preferably a prism 508 - providing a view of bottom surface of objects held by pickup tool 401. Pickup camera 506 is horizontally aligned to receive light from a horizontal direction and prismatic mirror 508 is arranged to direct light from the object held by pickup tool 401 above it into lookup camera 506. This allows to view the bottom side of objects, e.g. chips, in flip-chip applications.

Object dispenser 601 is located below a transfer opening 505 in working platform 501 so it can be reached by pickup tool 501.

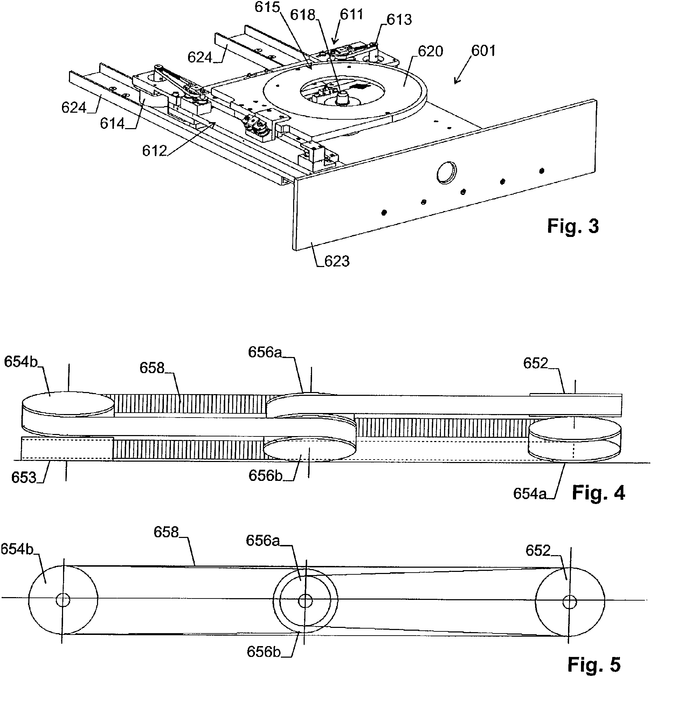

Fig. 3 shows a preferred design of object dispenser 601 especially suited for dispensing semiconductor chips arranged on a foil. It comprises an auxiliary X-positioning device 611 and an auxiliary Y-positioning device 612 for horizontal displacement along the X- and Y-direction, each driven by a motor 613 and 614, respectively. Object dispenser 601 further comprises an object holder 615 for holding the objects. In the present embodiment, object holder 615 comprises a circular frame 620 for holding and stretching a foil carrying semiconductor chips in an array. A needle 618 is provided for removing single chips to be received by pickup tool 401 reaching through transfer opening 505. By operating the auxiliary X- and Y-positioning devices 611 and 612, each chip can be positioned at transfer opening 505 and over needle 618 to be picked up by pickup tool 401. Hence, transfer window 505 can be smaller in horizontal direction than the array of objects. For attaching the foil of the chips to circular frame 620, retainer magnets or vacuum bores (not shown) are provided in circular frame 620.

In order to fit into utility space 5, the height of object dispenser 601 is low. Object holder 615 is located at its highest position with the auxiliary positioning devices 611 and 612 arranged laterally beside it.

For loading and unloading object dispenser 601, it is arranged on a drawer 623 arranged on rails 624 arranged below positioning table 2, by means of which it can be horizontally displaced along the Y-direction. In the present embodiment, object dispenser 601 can be removed from under platform 501 for access by drawing out drawer 623, object dispenser 601. For accurately placing object dispenser 601 in the closed position of drawer 623, it is pressed against a stop by means of a spring assembly (not shown).

Note that the front plate of drawer 623, which is located at front edge 106 of base wall 101 in the closed position of the drawer, is not shown in Figs. 1 and 2.

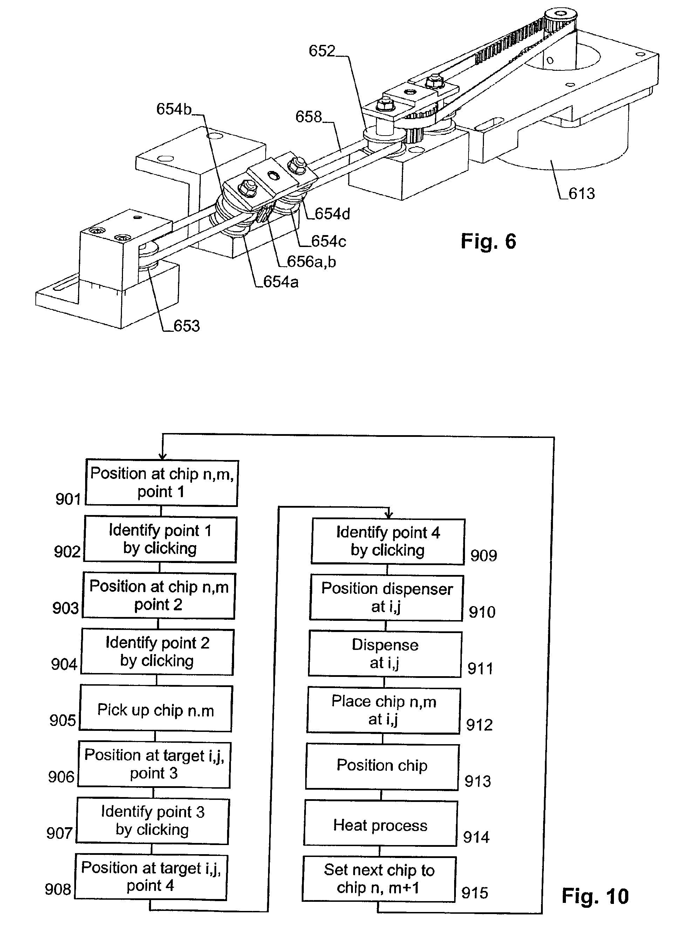

Figs. 4 and 5 show a first embodiment for auxiliary X- and Y-positioning devices 611 and 612 and Fig. 6 shows a second embodiment. These devices can be used in object dispenser 601, but they can also be used for any applications where a first member must be moved in respect to a second member, and their application is not limited to object dispenser 601.

In the embodiment of Fig. 4 and 5, a first and a second roller 652 and 653 having vertical axes are arranged on the first member, which is e.g. drawer 623. One of them (or any other roller or rollers of the device) is driven by a motor, such as one of the motors 613 and 614. A third and a fourth roller 656a and 656b are arranged on the second member, which is e.g. connected to object holder 615. Third and fourth roller 656a and 656b are connected to rotate about a common, tilted axis and have differing diameters. A single loop belt 658 (i.e. a single belt forming a loop) is guided around first roller 652 and second roller 653. It surrounds third roller 656a and fourth roller 656b from opposite sides as can be best seen from Fig. 5. The device further comprises guide rollers 654a and 654b having oppositely inclined axes.

The path of the belt 658 is as follows: From first roller 652 it is led around second guide roller 654b where it is offset vertically in downward direction. It then arrives at fourth roller 656b, which further offsets it vertically downwards such that it is now at the height of second roller 653. From second roller 653 it goes to first guide roller 654a, where it is offset vertically in upward direction, and then to third roller 656a, where it is further offset vertically in upward direction. From Third roller 656a it returns to first roller 652.

When driving belt 658 by rotating at least one of the rollers, third and fourth roller 656a and 656b are moving in respect to first and second roller 652 and 653 at a velocity that depends on the difference of the diameters of third and fourth roller 656a and 656b. Since this difference can be selected to be very small, a high resolution motion can be achieved.

In the embodiment of Fig. 4 and 5, guide rollers 654a and 654b are fixedly connected to the first member, i.e. to drawer 623.

In the embodiment of Fig. 6, four guide rollers 654a - 654d are connected to the second member, i.e. to object holder 615. All guide rollers 654a - 654d as well as the third and fourth roller 656a, 656b (which cannot be seen in Fig. 6 but have the same design as in Fig. 4) have parallel axes that are inclined in respect to the axes of first and second roller 652 and 653.

The belt in the embodiment of Fig. 6 starts at first roller 652 to guide roller 654d, third roller 656a, guide roller 654b, second roller 653, guide roller 654a, fourth roller 656b, guide roller 654c and back to first roller 652. Again, the guide rollers are used to vertically offset the belt, guide rollers 654d and 654b guiding it to an upward loop to contact third roller 656a and guide rollers 654a and 654c guiding it in a downward loop to contact fourth roller 656b.

Again, the rate of displacement can be adjusted by choosing a suitable difference between the diameters of third and fourth roller 656a, 656b.

The apparatus as shown in Figs. 1 to 6 can be controlled by a graphical user interface. Depending on the user's needs, windows containing certain operations or views can be opened on the screen or display 73.

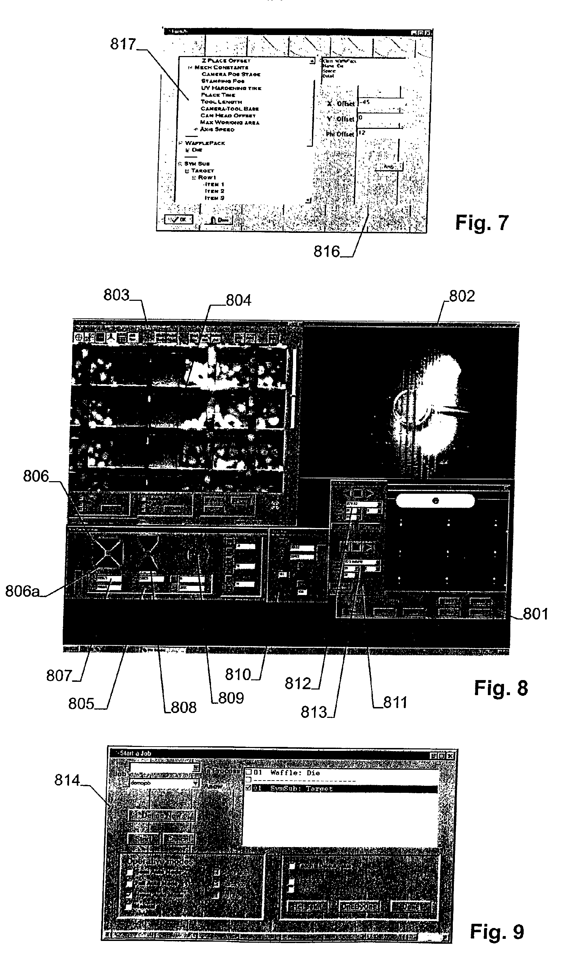

Fig. 7 shows a parameter window 816 for reading and setting system parameters. The system parameters are ordered in a tree 817 representing the structure of the apparatus. For example, the speed of the x-motor 205 or the Y-motor 211 can be accessed under an entry "positioning table", the amount of adhesive to be dispensed and the dispensing rate under an entry "dispenser".

Fig. 8 shows various further windows. A global positioning window 81 shows a symbolic image of the complete area that can be accessed by positioning table 2. By clicking any place in this image, positioning table 2 is moved to the corresponding position. When the mouse cursor is moved into global positioning window 801, it changes to a cross 804. When the center of the cross is at the appropriate position, a button on mouse 72 can be clicked and motors 205 and 211 are operated to move the table (i.e. the axis of microscopic camera 301) to the corresponding position ("click align"),

A macro positioning window 802 showing an image recorded by macroscopic camera 303 and a micro positioning window 803 showing an image recorded by microscopic camera 301 can both also be used for setting the X- and Y-position of positioning table 2. According to their higher magnification, they allow a more precise alignment of the table. By simultaneously displaying images of both cameras, the user can instantaneously switch between both views. Same as in window 801, the table can be moved by "click aligning" it with the help of window 802 or 803, i.e. by clicking the point where the axis of microscopic camera 301 should be moved to.

A main stage navigation window 805 serves to control all motors of positioning table 2, i.e. of X-motor 205, Y-motor 211, Z-motor 221 and rotation motor 231. When operating a X-offset button 806, first frame 20 is moved by a given distance. The current position of first frame 20 is displayed in a X-position field 807. The Y- and Z-position as well as the angular position can be controlled using similar controls 806a, 808 and 809.

A side stage window 810 allows to position object dispenser 601. A job navigation window 811 allows to choose an element in a matrix array of objects (such as chips) or targets (such as chip housings). A source table 812 shows the row and column of the object, a target table 813 the row and column of the target.

Fig. 9 shows a job window 814. A job is a sequence of functions as well as a set of predefined system parameters, which is stored under a job name. This allows to run previously stored processes. Assembling a -job becomes especially easy when it is carried out using "drag and drop" technique. Pickup or set down positions can be entered by means of the main stage navigation window 805 and then be stored, or they can be retrieved from indexed tables that were prepared previously.

A method for operating the apparatus is shown in the following for the example of picking a chip and placing it in a housing. The steps are shown in Fig. 10. It is assumed that the chips are stored in an array on a foil extended in object dispenser 601 and that the housings are arranged in an array 502 on working platform 501.

In a first step 901 alignment optics 3 is moved over a first chip position above the chip to be picked up. For this purpose, X-motor 205 and Y-motor 211 move the alignment optics over the chip and Z-motor 207 moves the chip's surface into the focal plane of alignment optics 3. The structures of the chip surface and a corner of the chip are displayed in macro positioning window 802 and micro positioning window 803. A positioning point in global positioning window 801 marks the current position of positioning table 2 (i.e. of the axis of microscopic camera 301) above needle tool 618.

Generally, the chip will not be exactly at the desired position. for instance, if table 2 is moved to an expected position of a first predefined point of the chip, such as a corner of the chip, it may appear at an offset to the center of the image macro positioning window 802 and micro positioning window 803. To correct this offset, the user moves cross 804 over the first predefined point and clicks it in one of the positioning windows (first click align 902). When the offset is large, he first uses global positioning window 801, for a smaller offset macro positioning window 802, and finally micro positioning window 803. After each click into global positioning window 801 or macro positioning window 802, the clicked point is moved into the center of the images. Once the user has clicked into micro positioning window 803, control unit 7 stores the x- and y-offset of the first point and then it moves positioning table 2 to a second predefined point of the chip to be picked up (step 903). The offset of the second point is now determined in the same manner as the offset of the first point (step 904). From the two offsets, control unit 7 calculates the horizontal chip offset as well as the horizontal chip rotation. Before picking up the chip in step 905, X- and Y-frame 20, 21 are displaced to compensate the chip offset as well as the "camera offset" mentioned above and rotating frame 23 is rotated by the inverse chip rotation. By displacing pickup tool 401 along the Z-direction and activating a vacuum source, the chip is picked up. The chip is removed from its foil by means of needle tool 618 in known manner.

While pickup tool 401 holds the chip, positioning table 2 moves its alignment optics over a first position of a target, i.e. a predefined point of a housing (step 606). The position and rotation offset of the housing is determined in the same manner as above in steps 906 - 909. Adhesive dispenser 412 is moved over the desired target position of the chip, taking into account the position and rotation offset of the chip housing (910). Lift 411 lowers adhesive dispenser 412 and dispenser 412 is activated (step 911). Complex adhesive structures can be applied by moving dispenser 412 horizontally while dispensing adhesive. After dispensing the adhesive, the chip is aligned in X-and Y-direction to the housing by using the housing offset as well as camera offset (step 912). The chip is lowered with Z-motor 221 (step 913). The vertical end position of pickup tool is selected such that a predefined pressure is applied on the chip. While pressing the chip against its target, pickup tool 401 is heated for hardening the adhesive (step 914). Positioning table 2 is now moved to the next chip and the procedure starts anew (step 915).

Placing a flip chip works in the same manner as above. However, in this case, after picking up the chip, it is viewed from below by moving it over lookup camera 506 for alignment.

In applications where the position of an object (such as a laser diode) depends on operational parameters of the object, the object can be moved by positioning table 2 while the object is being operated. For example, a laser diode can be aligned with a lens by measuring a light intensity at a desired point while the diode or the lens is being moved for finding an optimum alignment.

Measurements where a distance between two points is to be determined can be carried out by clicking both points. For increasing the accuracy of the distance between the two points, not only the mechanical positioning information, but also the pixel information, i.e. the pixel positions in the corresponding images, can be taken into account. For measuring such a distance, positioning table (2) is first positioned at a first location and a first image is recorded by camera 301. The first image is displayed on the computer screen. The user locates a first point in the first image by moving the cursor with mouse 72 over a first pixel of the first point in the first image. Then, positioning table 2 is moved by an offset to a second location, where a second image is recorded by camera 301 and displayed on the screen. The user locates a second point in the second image by moving the cursor over a second pixel of the second point in the second image. Computer 71 now calculates the distance by adding the offset and the pixel locations of the respective points in the images, multiplying the latter with the resolution of camera 301.

## Claims

1. An apparatus for picking and placing small objects comprising
a housing (1),
a working platform (501) mounted in the housing (1),
a tool holder (222) arranged above the working platform,
a pickup tool (401) arranged on said tool holder (222) for picking objects and transferring them over the working platform,
at least one camera (301, 303) mounted to said tool holder (222),
X-, Y- and Z-positioning motors (205, 211, 221) for displacing the tool holder (222) in horizontal X- and Y-directions and in a vertical Z-direction, and
a control unit (7) having a display (73) for displaying an image recorded by said camera and an input device (72) for controlling an operation of said positioning motors (205, 211, 221).

2. The apparatus of claim 1 further comprising
an object dispenser (601) for dispensing said objects,
a transfer opening (505) in said working platform, wherein said object dispenser (601) is arranged below said transfer opening (505) for being reached by said pickup tool (401) through said transfer opening (505).

3. The apparatus of claim 2 further comprising a horizontally displaceable drawer (623) arranged below said transfer opening (505), wherein said object dispenser (601) is arranged on said drawer (623) for being removed from under said working platform (501).

4. The apparatus of any of the claims 2 or 3 further comprising auxiliary X- and/or Y-positioning devices (611, 612) for horizontally displacing said object dispenser (601) in respect to said transfer opening (505).

5. The apparatus of any of the claims 2 to 4 wherein said object dispenser (601) comprises an object holder (615) for holding a plurality of objects in an array.

6. The apparatus of any of the preceding claims wherein said working platform (501) comprises a horizontal plate.

7. The apparatus of any of the preceding claims further comprising
a vertical stationary back wall (102) of said housing (1),
an upper and a lower horizontal guide rail (104) mounted along said X-direction to said stationary back wall (102),
upper and lower slides (202) guided by and displaceable along said guide rails (104), and
a first movable frame (20) mounted to said slides (202) and with movable vertical side walls (201b, 201c),
wherein said tool holder (222) is mounted on said movable frame (20) between said movable vertical side walls (201b, 201c).

8. The apparatus of claim 7 wherein said first movable frame (20) comprises a movable vertical back wall (201a) mounted to said slides (202) and/or a movable horizontal wall (201d) arranged between and connected to said movable side walls (201b, 201c).

9. The apparatus of any of the claims 7 or 8 further comprising a support (209) mounted to said first movable frame (20) at a forward end of said first movable frame (20) remote from said slides (202), wherein said support (209) is connected to said housing (1) for sliding along said x-direction and transferring lifting forces from said forward end to said housing.

10. The apparatus of any of the claims 7 to 9 wherein said housing (1) further comprises
a horizontal bottom wall (101) and
at least one stationary vertical side wall (103) connected to said stationary back wall (102) and said bottom wall (101).

11. The apparatus of any of the preceding claims further comprising
a first camera (301) mounted to said tool holder (222) for imaging said objects with a first resolution, and
a second camera (303) mounted to said tool holder (222) for imaging said objects with a second resolution smaller than said first resolution.

12. The apparatus of claim 11 wherein said first and second camera (301, 303) are aligned along non-parallel first and second camera axes, wherein said camera axes intersect in an intersection point and wherein both cameras are focused on said intersection point.

13. The apparatus of any of the claims 11 or 12 wherein said first camera (301) is aligned along a vertical axis.

14. The apparatus of any of the claims 11 to 13 wherein said control unit comprises a display (72) for concurrently displaying a first image from said first camera and a second image from said second camera.

15. The apparatus of any of the preceding claims further comprising a first camera (301) mounted to said tool holder (222) and directed along a vertical first camera axis for imaging said objects from above, wherein said pickup tool (401) is designed to pick up objects at a pickup point below said tool holder (222), and wherein a distance between said first camera axis and said pickup point is stored in said control unit (7) for calculating an offset between a pixel in an image of said first camera (301) from said pickup point.

16. The apparatus of any of the preceding claims further comprising a rotation motor (231) for rotating said pickup tool (401) about a vertical pickup axis.

17. The apparatus of any of the preceding claims further comprising a lookup camera (506) and a mirror (508) for viewing objects held by said pickup tool (401) from below, wherein said lookup camera (506) is arranged to receive light from a horizontal direction and said mirror is arranged to direct light from an object above it into said lookup camera (401), and in particular wherein said pickup camera is located between a working platform (501) of the apparatus and a stationary bottom wall (101) of the apparatus.

18. The apparatus of any of the preceding claims wherein said control unit (7) is designed for moving a cursor over an image from said camera (301, 303) displayed on said display (72) in response to an operation of said input device and for moving said tool holder (222) over a position indicated by said cursor.

19. The apparatus of any of the preceding claims further comprising a horizontally displaceable drawer (623) arranged below said positioning table (2).

20. The apparatus of any of the preceding claims further comprising means (7) for measuring a distance between two points by positioning said positioning table (2) at a first location, recording a first image by said camera, displaying said first image, locating a first point in said first image by moving a cursor over a first pixel of said first point in said first image, moving said positioning table by an offset to a second location, recording a second image by said camera, displaying said second image, locating a second point in said second image by moving said cursor over a second pixel of said second point in said second image, and calculating said distance from said offset and from a pixel location of said first and said second pixel in said first and said second image.

21. A displacement device for displacing a first member in respect to a second member, in particular the apparatus of any of the preceding claims with such a displacement device, said displacement device comprising
a first and a second roller (652, 653) mounted to said first member,
a third and a fourth roller (656a, 656b) mounted to said second member, wherein said third and fourth roller (656a, 656b) are connected to rotate about a common axis and have differing diameters, and
a single loop belt (658) guided around said first and second roller (652, 653) and contacting said third and fourth rollers (656a, 656b) from opposite sides,
such that driving said belt (658) by rotating at least one of said rollers leads to an movement between said first and said second member.

22. The displacement device or apparatus of claim 21 wherein said first and said second roller (652, 653) have first and second rotation axes parallel to each other, said displacement device further comprising guide rollers (654a - 654d) having guide roller axes arranged at an angle to said first and second rotation axes for offsetting said belt (658) along said first and second rotation axes.

23. The displacement device or apparatus of claim 22 wherein said common axis is parallel to said guide roller axes.

24. The displacement device or apparatus of any of the claims 22 or 23 wherein said guide rollers (654a - 654d) are arranged on said second member and/or wherein said third and forth rollers (656a, 656b) are arranged between said guide rollers (654a - 654d).

25. A method for operating the apparatus of any of the preceding claims comprising the steps of
displaying at least one image of said object recorded by said camera (301, 303) on said display (722) before picking said object up,
measuring a position and rotation of said object by manually identifying a first and a second predefined point of said object in said display,
displaying an image of a target in said display (722),
measuring a position and rotation of said target by manually identifying a third and a fourth predefined point in said display,
placing said object at a predefined position in said target using the measured positions and rotations.

26. The method of claim 25 wherein the position and rotation of said object is identified by moving a cursor to said first and then said second predefined point using said input device (721), and wherein the position and rotation of said target is identified by moving the cursor to said third and then said fourth predefined point using said input device.

27. The method of any of the claims 25 or 26 wherein said object is picked up after measuring the first and second predefined point.
